(19)

Europäisches Patentamt

European Patent Office

Office européen des brevets

(11) **EP 3 901 648 A1**

(12) **EUROPEAN PATENT APPLICATION**

(43) Date of publication:
**27.10.2021 Bulletin 2021/43**

(51) Int Cl.:
**G01R 33/54** *(2006.01)*          **G01R 33/561** *(2006.01)*
**G01R 33/565** *(2006.01)*

(21) Application number: **20171345.0**

(22) Date of filing: **24.04.2020**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(71) Applicants:
• **Siemens Healthcare GmbH**
  **91052 Erlangen (DE)**

• **Universitätsklinikum Erlangen**
  **91054 Erlangen (DE)**

(72) Inventors:
• **Gumbrecht, Rene**
  **91074 Herzogenaurach (DE)**
• **Herrler, Jürgen**
  **91058 Erlangen (DE)**
• **Liebig, Patrick**
  **91052 Erlangen (DE)**
• **Nagel, Armin**
  **91088 Bubenreuth (DE)**

(54) **METHOD AND DEVICE FOR CONTROLLING A MAGNETIC RESONANCE IMAGING SYSTEM**

(57)    The invention describes a pulse-design unit (12) for creating pulse data (SD, SD', SD") for controlling a magnetic resonance system (1) comprising a data interface (21) designed for receiving an examination scheme (E) and a calculation module (20) designed for generating pulse data (SD) based on an examination scheme (E), wherein the pulse-design unit (12) comprises a data grid and/or parameter values created from map pairs (M, M') of a plurality of patients and is designed to select and/or calculate pulse data (SD) using the data grid and/or parameter values and a provided examination scheme (E). The invention further describes a method and a control device for controlling an MRI system and a related magnetic resonance imaging system.

FIG 1

EP 3 901 648 A1

**Description**

The invention describes a method and a device for controlling a magnetic resonance imaging system, especially based on B0 and B1 maps.

Magnet resonance imaging is performed at various values for the strength of the basic magnetic field. Besides "low" or "normal" or "high" fields (up to 3 T), magnet resonance imaging can also be performed with basic fields of higher than 3 T (Very High Fields, VHF) or 7 T (Ultra High Fields, UHF) .

In UHF imaging (but also beginning in VHF), a method called "parallel transmit channel" (pTx) becomes necessary to counteract B1 inhomogeneities due to the shorter wavelength. A way to design pTx pulses is called Universal Pulses (UP). Universal Pulses are designed upon a set of B0 and B1 maps from different volunteers. The advantage is that these pulses can now be applied without the necessity to re-acquire the B0 and B1 maps, which takes time during the actual acquisition. Alternatively, UP can be used as a starting value for the optimization to first speed up the optimization itself and secondly making it more robust via the avoidance of local minima in the optimization. This approach has shown promising result for non-selective pulse types that excite the whole volume at once.

In magnetic resonance imaging (MRI) however, so-called slab/slice-selective or reduced FOV pulses (in the following called "Selective Pulses"; SP) are used. These have in common that not the whole volume is excited but only a subset, from which a MR signal can be generated. Now the problem is that these pulses change dependent on their position. For example, a sagittal slice does need an entirely different pulse compared to a transversal one.

Up to now the decision which pulse to use for which selective pulse was performed manually and not integrated at all.

It is the object of the present invention to improve the known systems, devices and methods to facilitate an improvement in controlling a magnetic resonance imaging system.

This object is achieved by a pulse-design unit according to claim 1, a method according to claim 7, a control device according to claim 12 and a magnetic resonance imaging system according to claim 13.

The aim of the invention is an automated solution to find the optimal pulses, especially selective pulses, to form a pulse sequence. To reach this aim, a special unit ("pulse-design unit") is introduced that is able to provide pulses and/or optimize pulses that can be used to form the pulse sequence. These pulses are preferably pTx pulses. Since it is not necessary that the pulse-design unit applies the pulses directly (this can be done by the regular units of an MRI), it is not necessary that the pulse design unit provides the actual pulses, but information about the shape, duration, application channel and timing of pulses. Thus, the pulse-design unit provides "pulse data" that is data that comprises all necessary information for a pulse generator (e.g. a sequence control unit, a radio frequency transmission device or a gradient system interface) to generate the correct pulses.

Starting from a set of B0 and B1 maps ("map pairs") from various patients, the pulses are designed by interpolating them on a grid and/or by a neural network. On the grid, (selective) pulses can be generated for each orientation, thereby forming a dictionary of selective pulses. However, the pulses do not necessarily have to be designed to excite and record slices or slabs (selective pulses), but also voluminous regions like cubes or spheres (non-selective pulses). The kind of the desired measurement (body region, shape of the examination area, e.g. slices or cube) is given by a predefined examination scheme that is provided to the pulse-design unit. The optimal pulses for a measurement according to that examination scheme are then calculated by the invention. The examination scheme typically comprises information about the contrasts to be measured and the order and shape of sub-regions of a region of interest to be recorded.

For example, during an actual scan, depending on the orientation of the measurement, e.g. the orientation of a slice) given by an examination scheme, the optimal pulse data can be extracted from the dictionary or calculated by the neural network. Instead of using a fixed grid, a relative grid to the brain mask can also be employed (also designated as "dictionary" or realized by a neural network). Typically, the dictionary is advantageous for selective pulses, and the neural network can also be applied for both nonselective pulses and pulses selecting any kind of (arbitrary) sub-region.

A pulse-design unit according to the invention is suitable for creating pulse data for controlling a magnetic resonance system, i.e. data comprising sufficient information to create pulses for an MRI pulse sequence, especially information about pulse-shapes, duration, application channel and timing of pulses (relative or absolute). These pulses can be selective pulses or non-selective pulses. The pulse-design unit can be a physical unit or a software module in a computing unit (e.g. inside a control unit of an MRI system and comprises the following components:

A data interface designed for receiving an examination scheme, and especially also a map pair (B0 map and B1 map) and a calculation module designed for generating pulse data based on an examination scheme, and especially also on a map pair.

The pulse-design unit, especially its computing unit, comprises a data grid and/or parameter values created from map pairs of a plurality of patients and is designed to select and/or calculate pulse data using the data grid and/or parameter values and a provided examination scheme.

A suitable data interface is well known in the art and is used to input external data into the calculation module. It can be designed as data bus or as actual interface (e.g. USB) .

The general design of a suitable calculation module is also well known. For example, a calculation module comprises a memory, a processor (or controller) and a random access memory. However, the exact setup of the calculation unit (algorithm or hardware setup) is special.

The pulse-design unit, i.e. typically its computing unit, is designed to generate pulse data by using said data grid or parameter values. These components are created from (reference) map pairs of a plurality of different patients. Thus, an actual measurement does not necessarily need information about the actual patient, but can derive the optimal pulse data from its "knowledge" about the (reference) map pairs.

The generation of the pulse data can be accomplished by selecting pulse data from a predefined group of pulse data (e.g. from the grid being a dictionary) and/or by calculating pulse data using means that were specially designed by using the (reference) map pairs (e.g. with a neural network working with the parameter values).

The pulse data may be selective pulse data (for recording slabs or slices) or non-selective pulse data (for recording areas expanded in all three spatial axes like cubes or spheres). It preferably comprises data to generate pTx pulses, especially complete pTx pulses with trajectories and RF shapes. Alternatively or additionally, the pulse data comprises parameters, preferably combined optimization values (COV), to generate/optimize pTx pulses from predefined pulses or B0/B1 maps of a patient previously measured. Preferably, the COV define a trajectory and/or regulate or optimize pulse shapes based on prior recorded B1/B0 maps. Thus, in most applications the pulse data provided by the pulse-design unit are complete pulses (especially pTx pulses) that can be arranged to form a pulse sequence or information to optimize predefined pulses (especially COV). For example, there exists a generic pulse sequence that is optimized by altering the pulses of the pulse sequence by using the COV that are generated by the pulse-design unit. Preferably, the pulse design unit is also designed to alter predefined pulses and/or to create a pulse sequence by using the generated pulse data.

A data grid is preferably present in form of a dictionary. The term "dictionary" means that values are sorted in an order that makes them detectable by knowing an examination scheme. This may be realized by a grid or a database structure.

Regarding provided data, it is preferred that also VOP data is provided together with the map pairs (VOP: "Virtual Observation Points"). The VOP data comprise (compressed) specific absorption rate (SAR) data designed to calculate SAR distribution. The SAR distribution describes where in a body region (e.g. the brain) local heating is expected, since in UHF an inhomogeneous distribution of hotspots due to SAR is generated.

A suitable method to generate pTx pulses from given trajectories, comprising gradient trajectories and RF pulse shapes (i.e. voltage curves), for a number of coil channels (every coil channel) is well known in the art. For example, combined optimization values are calculated which define the respective trajectory and regulate an RF pulse optimization.

The Combined Optimization Values (COV) are calculated offline with an optimization of the trajectory parameters ($P_t$) together with a weighting of the energy regularization ($\lambda_0$) during pulse-shape optimization: $COV:=[P_t, \lambda_0]$. This is done based on a normalized root mean square error (NRMSE) of the simulated flip angle (FA) distribution and the specific energy dose (SED, e.g. derived from the specific absorption rate SAR) of measurements from several patients. The optimal COV with the FA-NRMSE (homogeneity) and the maximum local SED with simulated pTx-pulse-design from datasets of a number N of patients (coil sensitivities, B0 maps, VOP data) and the weighting coefficients $w_H$ and $w_S$ is calculated by solving the minimization problem

$$\min_{COV} \sum_{p}^{N} \left[ w_H \exp\left( NRMSE_p\left( COV \right) \right) + w_S \exp\left( SED_p\left( COV \right) \right) \right]. \tag{1}$$

For each set of COV, the individual pulse optimization for N patients is simulated. From this, the NRMSE values and SED values are used according to the above formula. These values should be minimized during the optimization process (global optimization process). The COV for which this function gives the lowest value are selected.

An optimization of the respective pulse shape $b_0$ (especially the RF shape of all channels) is calculated similarly by solving the minimization problem

$$\min_{b_0} \sum_{p}^{N} \left[ w_H \exp\left( NRMSE_p\left( b_{0,COVopt} \right) \right) + w_S \exp\left( SED_p\left( b_{0,COVopt} \right) \right) \right]. \tag{2}$$

Alternatively or additionally to a grid (a dictionary), a neural network can be used to accomplish the task of the invention. This neural network is preferably a "Convolutional Neural Network" (CNN) that is trained with map pairs.

A method according to the invention for creating a dictionary of pulse data for controlling a magnetic resonance imaging system comprises the following steps:

- Providing a set of a plurality of (reference) map pairs from different patients, each map pair comprising a B0 map and a B1 map of a patient,
- calculating for each map pair a set of pulse data that is designed for applying pulses to measure different sub-regions (e.g. slices or cubes) in a region of interest,
- creating a dictionary comprising the calculated pulse data in relation with the respective sub-regions, e.g. slices or other volumes.

A method according to the invention for creating a trained neural network, especially a CNN, for controlling a magnetic resonance imaging system comprises the following steps:

- Providing a set of a plurality of map pairs from different patients, each map pair comprising a B0 map and a B1 map of a patient,
- providing an examination scheme for each map pair the respective patient is examined with,
- providing a ground truth for each map pair comprising COV and/or pTx pulses,
- providing an untrained neural network that is designed to assign for each map pair a COV and/or a pTx pulse respective to the examination scheme,
- training of the neural network based on the map pairs as input and the respective ground truth.

Thus, the neural network "learns" by using the map pairs, which pTx and/or which COV are optimal for the respective map pairs.

Preferably, the training is achieved by solving at least one of the above minimization problems. In the course of calculating the pulse data it is preferred that for a predefined map pair COV are calculated with the minimal value is selected from the solution of the above minimization problem and not to solve the equations as general optimization problem like it is done when searching for good COV.

A trained neural network, especially a CNN, according to the invention is trained by a method according to the invention. A method according to the invention for controlling a magnetic resonance imaging system comprises the following steps:

- providing a pulse-design unit according to the invention,
- providing an examination scheme comprising information about the contrasts to be measured and the order and shape of sub-regions of a region of interest to be recorded,
- generating pulse data with the pulse-design unit based on the examination scheme (and especially also by using a map pair), wherein this is preferably achieved in that the pulse data for the sub-regions are chosen from the grid (dictionary) of the pulse-design unit depending from the examination scheme and/or in that the pulse data is calculated by the neural network by measuring map pairs of the respective patient and inputting these map pairs into the neural network,
- creating a pulse sequence for a measurement with the magnetic resonance imaging system from the generated pulse data.

It should be noted that there are no map pairs necessarily needed during the actual measurement when using the dictionary. However, a calculation with the neural network preferably uses map pairs of the actual patient and may result in a faster method than the use of a dictionary. Thus, the use of a dictionary or a neural network may be made dependent of the actual case.

If map pairs (i.e. B0 maps and B1 maps) of a patient are measured, they may be analyzed by the neural network. In the course of the analyzation, pulse data (COV and/or pTx) may be assigned to the patient in total or to slices in the field of view. This allows the optimization of pulse data (e.g. COV) during a measurement. In the case, no maps should be acquired, the use of the dictionary is advantageous, as said above.

A pulse sequence can be created by replacing predefined "blocks" of signals by signals based on the selected pulse data.

A control device according to the invention for controlling a magnetic resonance imaging system comprises the following components:

- A pulse-design unit according to the invention,
- a data interface designed for receiving an examination scheme comprising information about the contrasts to be measured and the order of sub-regions of a region of interest to be recorded,
- a sequence unit designed for creating a pulse sequence for a measurement with the magnetic resonance imaging system from pulse data generated by the pulse-design unit. This sequence-unit is preferably part of the pulse-design unit.

Thus, the control device is designed to perform the method according to the invention. It may comprise additional units or devices for controlling components of a magnetic resonance imaging system, e.g. a sequence control unit for measurement sequence control, a memory, a radio frequency (RF) transmission device that generates, amplifies and transmits RF pulses, a gradient system interface, a radio frequency reception device to acquire magnetic resonance signals and/or a reconstruction unit to reconstruct magnetic resonance image data.

A magnetic resonance imaging system comprising a control device according to the invention.

Some units or modules of the control device mentioned above, especially the pulse-design unit, can be completely or partially realized as software modules running on a processor of a control device. A realization largely in the form of software modules can have the advantage that applications already installed on an existing system can be updated, with relatively little effort, to install and run these units of the present application. The object of the invention is also achieved by a computer program product with a computer program that is directly loadable into the memory of a control device of a magnetic resonance imaging system, and which comprises program units to perform the steps of the inventive method when the program is executed by the control device. In addition to the computer program, such a computer program product can also comprise further parts such as documentation and/or additional components, also hardware components such as a hardware key (dongle etc.) to facilitate access to the software.

A computer readable medium such as a memory stick, a hard-disk or other transportable or permanently-installed carrier can serve to transport and/or to store the executable parts of the computer program product so that these can be read from a processor unit of a control device. A processor unit can comprise one or more microprocessors or their equivalents.

Particularly advantageous embodiments and features of the invention are given by the dependent claims, as revealed in the following description. Features of different claim categories may be combined as appropriate to give further embodiments not described herein.

A preferred pulse-design unit is designed to generate selective pulse data that comprises data about slice-selective pulses for the acquisition of MRI data. The data comprises preferably information about selective pulses that are on a spoke trajectory in k-space. It is generally preferred that the k-space lines used to calculate selective pulse data (all) lead though the center of k-space. However, depending on the desired examination, the pulse-design unit may also be designed to generate non-selective pulses.

A preferred pulse-design unit comprises a dictionary comprising generated pulse data. The dictionary is preferably created by a method comprising the steps:

- providing a set of a plurality of map pairs from different patients, each map pair comprising a B0 map and a B1 map of a patient,
- calculating for each map pair a set of pulse data that is designed for applying pulses to measure different sub-regions in a region of interest,
- creating a dictionary comprising the calculated pulse data in relation with the respective sub-regions.

According to a preferred method, the relation of the pulse data with respective sub-regions in the dictionary is achieved with a labeling of the pulse data. Alternatively or additionally, the relation of the pulse data with respective sub-regions is achieved with an arrangement of the pulse data on a grid representing the sub-regions.

A preferred pulse-design unit comprises a neural network, preferably a convolutional neural network, designed to generate pulse data, while with the term "generating", typically "choosing" and/or "calculating" is meant. Preferably, the data interface is designed for receiving a map pair, and the calculation module is designed for generating pulse data based on an examination scheme and a map pair.

It is preferred that the neural network is trained by a method comprising the following steps:

- providing a set of a plurality of map pairs from different patients, each map pair comprising a B0 map and a B1 map of a patient,
- providing an examination scheme for each map pair the respective patient is examined with,
- providing a ground truth for each map pair comprising COV and/or pTx pulses,
- providing an untrained neural network that is designed to assign for each map pair COV and/or a pTx pulse respective to the examination scheme,
- training of the neural network based on the map pairs as input and the respective ground truth.

According to a preferred embodiment of the invention, the pulse data is designed to control data recording of an MRI system with a basic magnetic field greater than 3 T (VHF), preferably greater than 7 T (UHF).

According to a preferred embodiment of the invention, the pulse data is designed for an MRI system comprising a predefined number of RF coils of the RF transmission antenna system for applying RF-signals. The pulse data comprises control data for a number of RF coil, especially for each RF coil, and preferably additionally also control data for gradient coils of the MRI system.

According to a preferred embodiment of the invention, the pulse data is designed for parallel transmission, preferably for parallel transmission of universal pulses and/or pulses calculated with COV. Universal pulses and pulses calculated with COV have in common that both are completely (universal) or partly (COV) based on pre-calculated pulses. The method is generally suitable for any kind of precalculated pulses, however, COV-based pulses are particularly preferred.

According to a preferred embodiment of the invention, the pulse data comprises data about the shape of signals of a pulse sequence, preferably the shape of RF pulses (also called "RF shapes", i.e. voltage curves), especially of all channels of the transmission coils. It is preferred that also the shape of gradient pulses, and/or data about a trajectory in k-space and constraints are part of the pulse data.

According to a preferred embodiment of the invention, the pulse data for an individual sub-region is calculated from the pulse data of the map pairs according to this sub-region. It is preferred that respective data of different patients is averaged or optimal respective pulse data is chosen from pulse data created of a map pair.

Preferably, each slice with every orientation of B1/B0 masks from previously acquired map pairs can be grouped with respect to similarity to each other. On each B1/B0 map cluster, a pulse can be designed. During an actual acquisition, a pulse dependent on the similarity of the acquired B0/B1 maps (map pairs) and the most similar one from the dictionary can be played out.

Preferably, the universal field of view (e.g. a 3D-FOV) or masks is/are divided in a number of slabs or slices. Slab-specific spoke positions (spoke trajectories used for exciting the slab) and energy weights are optimized universally (a dictionary is created) or individually with COV for the slabs (COV_slabi: = $[P_{Spokes,i}, \lambda_i]$), where i denotes the number of COV/slab.

Derived from the preceding description, there are two preferred options to achieve the desired results that can be applied for themselves or in combination with another. The first preferred option needs an optimization of COV and the training of a neuronal network to assign COV to given map pairs. During a measurement there is done a (fast) acquisition of map pairs of a patient (B0/B1 maps) and a calculation (that can especially be a selection) of COV matching the inputted map pairs by the trained neural network. A trajectory for pulse data is defined by the resulting COV data, pulse shapes are optimized on the basis of the resulting COV and corresponding pulse shapes (especially online).

The same can be achieved by using pTx pulses instead of COV (replace COV with pTx pulses in the preceding paragraph). Also a combination of COV and pTx pulses is possible, e.g. an additional optimization of pulse forms of selected pulses based on the COV.

The second preferred option needs an optimization of prepared pTx pulses for different B1/B0 maps depending on the position of a slab to be measured (e.g. relative to a coil or the patient). Then a dictionary is created that preferably assigns each slab position a universal pulse. In the course of a measurement there is no need for the acquisition of map pairs or pTx optimization. Universal pulses are chosen from the dictionary based on a slab-position to be excited during a measurement.

Regarding the first preferred option, also a dictionary can be used, as long as it comprises a grid of COV (e.g. a dictionary created in the second option as long as it comprises COV). Based on this dictionary there are now COV chosen.

Regarding the second option, also a neural network (form the first option) can be used. This alternative can be nevertheless advantageous. The neural network chooses prepared pTx pulses (and preferably no COV that are further optimized) and inserts them in a pulse sequence or applies them directly.

According to a preferred method for an examination of a patient, the pulse data is calculated by a neural network (of the pulse-design unit) by measuring map pairs of the respective patient and inputting these map pairs into the neural network.

According to a preferred method for an examination of a patient, pulse data for sub-regions are chosen from a dictionary of the pulse-design unit depending on the examination scheme.

According to a preferred (control ) method, for a sub-region (of the examination scheme) for which no pulse data is present in the dictionary, intermediate pulse data is calculated from pulse data according to sub-regions of the dictionary that are adjacent to the sub-region (of the examination scheme). It is further preferred that the creation of the intermediate pulse data comprises averaging of pulse data or choosing the pulse data of the nearest sub-region in the dictionary.

In a preferred embodiment according to the invention, components are part of a data network, wherein preferably the data network and the control device of a magnetic resonance imaging system are in data-communication with each other, wherein the data-network preferably comprises parts of the internet and/or a cloud-based computing system, wherein preferably components performing the method according to the invention are realized in this cloud-based computing system.

Such a networked solution could be implemented via an internet platform and/or in a cloud-based computing system.

The method may also include elements of "cloud computing". In the technical field of "cloud computing", an IT infrastructure is provided over a data network, e.g. a storage space or processing power and/or application software. The communication between the user and the "cloud" is achieved by means of data interfaces and/or data transmission protocols.

In the context of "cloud computing", in a preferred embodiment of the method according to the invention, provision of data via a data channel (for example a data network) to a "cloud" takes place. This "cloud" includes a (remote) computing system, e.g. a computer cluster that typically does not include the user's local machine. This cloud can be made available in particular by the medical facility, which also provides the medical imaging systems. In particular, the image acquisition data is sent to a (remote) computer system (the "cloud") via a RIS (Radiology Information System) or a PACS (Picture Archiving and Communication System).

Within the scope of a preferred embodiment of the system according to the invention, the abovementioned units (especially the dictionary unit and/or the sequence unit) Are present on the "cloud" side. A preferred system further comprises, a local computing unit connected to the system via a data channel (e.g. a data network, particularly configured as RIS or PACS). The local computing unit includes at least one data receiving interface to receive data. Moreover, it is preferred if the local computer additionally has a transmission interface in order to send data to the system.

Advantages of the invention are that it provides a fully automated solution while it uses a grid or alternatively a clustering approach to find the pulses that correspond to predefined orientations. It additionally allows a fast selection of the correct pulses, enabling universal pulses, or using them as a starting value.

Other objects and features of the present invention will become apparent from the following detailed descriptions considered in conjunction with the accompanying drawings. It is to be understood, however, that the drawings are designed solely for the purposes of illustration and not as a definition of the limits of the invention.

Figure 1 shows a simplified MRI system according to an embodiment of the invention.

Figure 2 shows a block diagram of the process flow of a preferred method according to the invention.

Figure 3 shows a preferred method according to the invention for creating a dictionary.

Figure 4 shows a preferred method according to the invention for creating pulses by using a dictionary.

Figure 5 shows a preferred method according to the invention for creating pulses by using a neural network.

In the diagrams, like numbers refer to like objects throughout. Objects in the diagrams are not necessarily drawn to scale.

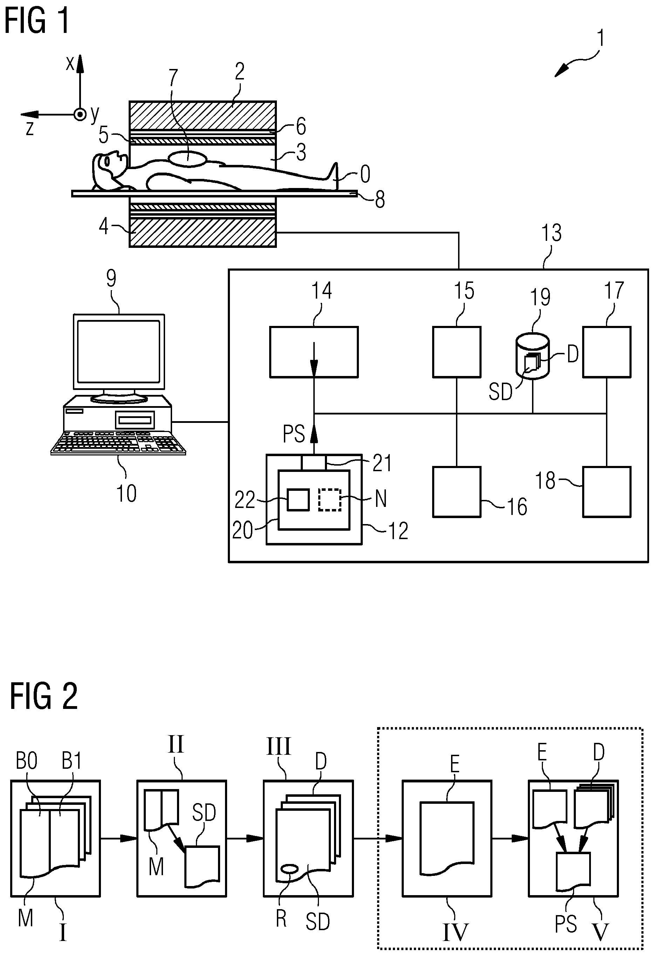

Figure 1 shows a schematic representation of a magnetic resonance imaging system 1 ("MRI system"). The MRI system 1 includes the actual magnetic resonance scanner (data acquisition unit) 2 with an examination space 3 or patient tunnel in which a patient or test person is positioned on a driven bed 8, in whose body the actual examination object is located.

The magnetic resonance scanner 2 is typically equipped with a basic field magnet system 4, especially suited for producing a very high field or an ultra high field, a gradient system 6 as well as an RF transmission antenna system 5 and an RF reception antenna system 7. In the shown exemplary embodiment, the RF transmission antenna system 5 is a whole-body coil permanently installed in the magnetic resonance scanner 2, in contrast to which the RF reception antenna system 7 is formed as local coils (symbolized here by only a single local coil) to be arranged on the patient or test subject. In principle, however, the whole-body coil can also be used as an RF reception antenna system, and the local coils can respectively be switched into different operating modes.

The basic field magnet system 4 is designed in a typical manner so that it generates a basic magnetic field in the longitudinal direction of the patient, i.e. along the longitudinal axis of the magnetic resonance scanner 2 that proceeds in the z-direction. The gradient system 6 typically includes individually controllable gradient coils in order to be able to switch (activate) gradients in the x-direction, y-direction or z-direction independently of one another.

The MRI system 1 shown here is a whole-body system with a patient tunnel into which a patient can be completely introduced. However, in principle the invention can also be used at other MRI systems, for example with a laterally open, C-shaped housing, as well as in smaller magnetic resonance scanners in which only one body part can be positioned.

Furthermore, the MRI system 1 has a central control device 13 that is used to control the MRI system 1. This central control device 13 includes a sequence control unit 14 for measurement sequence control. With this sequence control unit 14, the series of radio frequency pulses (RF pulses) and gradient pulses can be controlled depending on a selected pulse sequence PS (especially comprising selected pulses created by the method according to the invention) to acquire magnetic resonance images within a measurement session. For example, such a series of pulse sequence PS can be predetermined within a measurement or control protocol (comprising results of the method according to the invention). For example, different control protocols for different measurements or measurement sessions are typically stored in a memory 19 and can be selected by and operator and modified by including the correct pulses created by the method according to the invention) and then be used to implement the measurement.

To output the individual RF pulses of a pulse sequence PS, the central control device 13 has a radio frequency transmission device 15 that generates and amplifies the RF pulses and feeds them into the RF transmission antenna system 5 via a suitable interface (not shown in detail). To control the gradient coils of the gradient system 6, the control device 13 has a gradient system interface 16. The sequence control unit 14 communicates in a suitable manner with the radio frequency transmission device 15 and the gradient system interface 16 to emit the pulse sequence PS.

Moreover, the control device 13 has a radio frequency reception device 17 (likewise communicating with the sequence control unit 14 in a suitable manner) in order to acquire magnetic resonance signals (i.e. raw data) for the individual measurements, which magnetic resonance signals are received in a coordinated manner from the RF reception antenna system 7 within the scope of the pulse sequence PS.

A reconstruction unit 18 receives the acquired raw data and reconstructs magnetic resonance image data therefrom for the measurements. This reconstruction is typically performed on the basis of parameters that may be specified in the respective measurement or control protocol. For example, the image data can then be stored in a memory 19.

Operation of the central control device 13 can take place via a terminal 10 with an input unit and a display unit 9, via which the entire MRI system 1 can thus also be operated by an operator. MR images can also be displayed at the display unit 9, and measurements can be planned and started by means of the input unit (possibly in combination with the display unit 9), and in particular suitable control protocols can be selected (and possibly modified) with suitable series of pulse sequence PS as explained above.

The control device 13 comprises a pulse-design unit 12, with a computing module 20 and a data interface 21 and a sequence-unit 22 designed to perform the method according to the invention. These components may appear to be software modules. In this example, the sequence unit 22 is part of the computing unit 20 of the pulse-design unit 12 so that the pulse-design unit 12 is suited to generate the pulse data SD and directly create a pulse sequence by using the generated pulse data SD. In this example, the pulse-design unit 12 is designed for receiving a dictionary D with (selective) pulse data SD that is stored in the memory 19. Alternatively, or additionally the pulse-design unit 12 may comprise a neural network N as indicated by the dashed box.

The data interface 21 is designed for receiving an examination scheme E (see e.g. following figures) comprising information about the contrasts to be measured and the order of sub-regions of a region of interest to be recorded,

The sequence unit 22 is designed for creating a pulse sequence PS for a measurement with the resonance imaging system based on the examination scheme E and the pulse data SD of the dictionary D wherein the pulse data SD for the sub-regions are chosen from the dictionary D according to the examination scheme E.

The MRI system 1 according to the invention, and in particular the control device 13, can have a number of additional components that are not shown in detail but are typically present at such systems, for example a network interface in order to connect the entire system with a network and be able to exchange raw data and/or image data or, respectively, parameter maps, but also additional data (for example patient-relevant data or control protocols).

The manner by which suitable raw data are acquired by radiation of RF pulses and the generation of gradient fields, and MR images are reconstructed from the raw data, is known to those skilled in the art and thus need not be explained in detail herein.

Figure 2 shows a block diagram of the process flow of a preferred method according to the invention for controlling a magnetic resonance imaging system 1 (see. e.g. figure 1). At first (steps I to III), a dictionary d is created, after that (steps IV and V), this dictionary D is used to create a pulse sequence PS to control the MRI system. Alternatively, a neural network N may be trained and used for the method.

In step I, a set of a plurality of map pairs M from different patients is provided, each map pair M comprises a B0 map B0 and a B1 map B1 of a patient.

In step II, a set of (selective) pulse data SD is calculated for each map pair M. This (selective) pulse data SD is designed for applying pulses to measure different sub-regions (e.g. slices or cubes) in a region of interest.

In step III, a dictionary D is created. This dictionary D comprises the calculated (selective) pulse data SD in relation with the respective sub-regions R.

In step IV, an examination scheme E is provided comprising information about the contrasts to be measured and the order of sub-regions R of a region of interest to be recorded.

In step V, a pulse sequence PS for a measurement is created with the resonance imaging system based on the examination scheme E and the (selective) pulse data SD of the dictionary D wherein the (selective) pulse data SD for the sub-regions R are chosen from the dictionary D according to the examination scheme E.

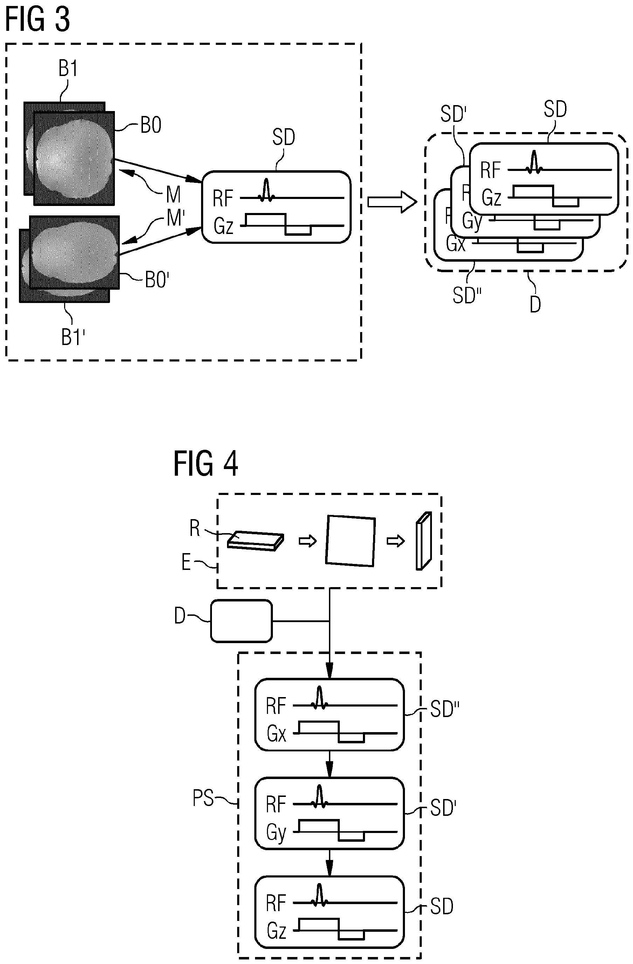

Figure 3 shows a preferred method according to the invention for creating a dictionary. It depicts the process of steps I to III of figure 2.

starting on the left side, there are two map pairs M, M', each comprising a B0 map B0, B0' and a B1 map B1, B1' of a patient. These two map pairs M, M' should represent a plurality of many map pairs of different patients.

Based on these map pairs M, M', a set of (selective) pulse data SD is calculated. This calculation is based on a predefined sub-region (e.g. a slice). In the shown example (dashed box), the (selective) pulse data SD comprises an RF pule and a Z-gradient representing a (selective) pulse applied to measure a slice expanded in the Z-direction. Now there are calculated many sets of (selective) pulse data SD, SD', SD" for different slices. In This example, two other sets of (selective) pulse data is calculated one set of (selective) pulse data SD', SD" with a Y-gradient and one with a X-gradient to measure slices oriented in the Y- and X direction. The calculated sets of (selective) pulse data SD, SD', SD" are combined in a dictionary D shown on the right.

Figure 4 shows a preferred method according to the invention for creating (selective) pulses by using a dictionary, e.g. as shown in figure 3.

At first, an examination scheme E is provided, that comprises here the measurement of three slices (as sub-regions R) oriented in X-, Y- and Z-direction. By using the dictionary, a pulse sequence PS is created comprising the sets of (selective) pulse data SD, SD', SD" that have been calculated in figure 3, comprising gradients on the X-, Y- and Z-axis.

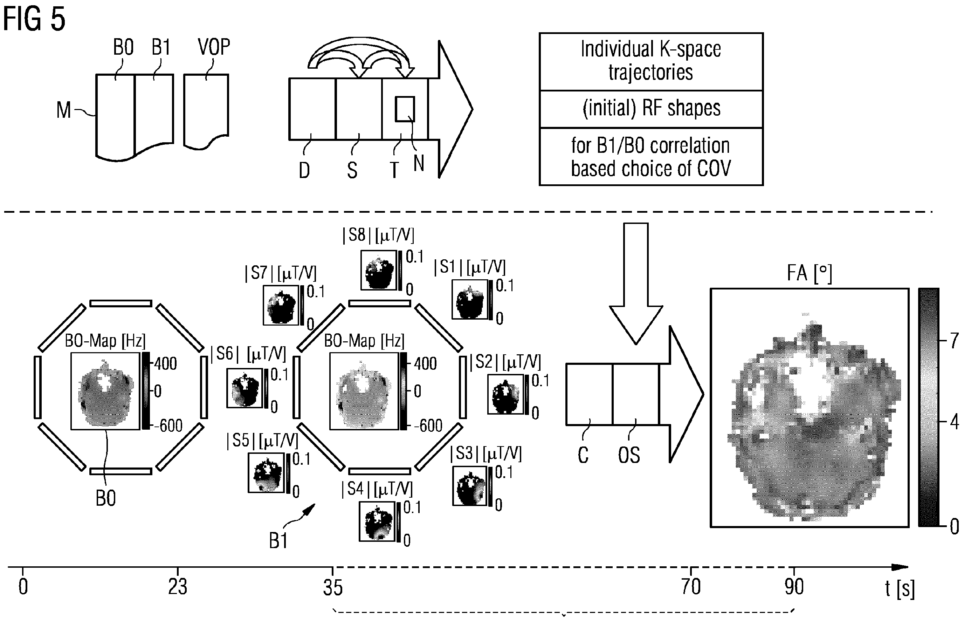

Figure 5 shows a preferred method according to the invention for creating (selective) pulses by using a neural network N. In addition to map pairs M from different patients, each map pair comprising a B0 map B0 and a B1 map B1 of the patient, also data of Virtual Observation Points VOP is provided. However, the use of VOP data VOP is optional.

In the course of an offline optimization (upper big arrow) various COV are calculated and included in an (optional) dictionary D. In addition, corresponding RF shapes S are calculated and these values are the basis for a training T of a neural network N. The results are individual k-space trajectories, (initial) RF shapes and a choice of COV for a B1/B0 correlation.

Then (below the long dashed line), in the course of an online optimization, B0 maps B0 and B1 maps B1 of a patient are measured and a choice C of COV plus a determination of initial RF shapes is performed, in this case by using the trained neural network, (horizontal big arrow in the middle). This is preferably followed by an optional shaping OS procedure, wherein an individual pulse shaping is provided. This shaping can also be achieved by a/the neural network.

At the bottom, a timescale is shown in form of an arrow, where the time t runs from left to right. Several points of time are marked in seconds, wherein the dashed part can be spared by the invention compared to the state of the art (55 seconds). At point 0, the adjustment starts, 23 seconds later a B0 mapping is ready, 35 seconds later a B1 mapping is complete. In the state of the art there is now following a B1+ mapping (75 seconds from the start) and a pTx pulse calculation (90 seconds from the start). This time can be economized by the present method that provides the desired pulse sequence after 35 seconds. For example, by using a dictionary choosing predefined pTx pulses (e.g. Universal Pulses), neither additional sequence preparation time is needed nor a B0 mapping or B1 mapping.

Although the present invention has been disclosed in the form of preferred embodiments and variations thereon, it will be understood that numerous additional modifications and variations could be made thereto without departing from the scope of the invention. For the sake of clarity, it is to be understood that the use of "a" or "an" throughout this application does not exclude a plurality, and "comprising" does not exclude other steps or elements. The mention of a "unit" or a "device" does not preclude the use of more than one unit or device.

**Claims**

1. A pulse-design unit (12) for creating pulse data (SD, SD', SD") for controlling a magnetic resonance imaging system (1), the pulse-design unit (12) comprising a data interface (21) designed for receiving an examination scheme (E) and a calculation module (20) designed for generating pulse data (SD) based on an examination scheme (E), wherein the pulse-design unit (12) comprises a data grid and/or parameter values created from map pairs (M, M') of a plurality of patients and the pulse-design unit (12) is designed to select and/or calculate pulse data (SD) using the data grid and/or parameter values and a provided examination scheme (E).

2. The pulse-design unit according to claim 1, designed to generate selective pulse data (SD, SD', SD") that comprises data about slice-selective pulses for the acquisition of MRI data, preferably selective pulses on a spoke trajectory in k-space.

3. The pulse-design unit according to one of the preceding claims, comprising a dictionary (D) comprising generated pulse data (SD, SD', SD") in the data grid,

wherein the dictionary (D) is preferably created by a method comprising the steps:

- providing a set of a plurality of map pairs (M, M') from different patients, each map pair (M, M') comprising a B0 map (B0, B0') and a B1 map (B1, B1') of a patient,
- calculating for each map pair (M, M') a set of pulse data (SD, SD', SD") that is designed for applying pulses to measure different sub-regions (R) in a region of interest,
- creating a dictionary (D) comprising the calculated pulse data (SD, SD', SD") in relation with the respective sub-regions (R).

4. The pulse-design unit according to one of the preceding claims, comprising a neural network (N), preferably a convolutional neural network, designed to choose or generate pulse data (SD, SD', SD"), preferably wherein the data interface (21) is designed for receiving a map pair (M, M'), and the calculation module (20) is designed for generating pulse data based on an examination scheme (E) and a map pair (M, M'), preferably wherein the neural network (N) is trained by a method comprising the following steps:

- providing a set of a plurality of map pairs (M, M') from different patients, each map pair (M, M') comprising a B0 map (B0, B0') and a B1 map (B1, B1') of a patient,
- providing an examination scheme (E) for each map pair (M, M') the respective patient is examined with,
- providing a ground truth for each map pair (M, M') comprising COV and/or pTx pulses,
- providing an untrained neural network (N) that is designed to assign for each map pair (M, M') COV and/or a pTx pulse respective to the examination scheme (E),
- training of the neural network (N) based on the map pairs (M, M') as input and the respective ground truth.

4. The pulse-design unit according to one of the preceding claims, designed to generate pulse data (SD, SD', SD") that is designed to control data recording of an magnetic resonance imaging system (1) with a basic magnetic field greater than 3 T, preferably greater than 7 T.

5. The pulse-design unit according to one of the preceding claims, designed to generate

- pulse data (SD, SD', SD") that is designed for a magnetic resonance imaging system (1) comprising a predefined number of RF coils for applying RF signals and the pulse data (SD, SD', SD") comprising control data for each RF coil of an RF transmission antenna system (5) and preferably also control data for gradient coils (6) of the magnetic resonance imaging system (1),
and/or
- pulse data (SD, SD', SD") that is designed for parallel transmission, preferably for parallel transmission of universal pulses and/or pulses calculated with COV,
and/or
- pulse data (SD, SD', SD") comprising data about the shape of signals of a pulse sequence (PS), preferably the shape of RF pulses, and especially gradient pulses, and/or data about a trajectory in k-space and constraints.

6. The pulse-design unit according to one of the preceding claims, designed to generate pulse data (SD, SD', SD") for an individual sub-region (R) that is calculated from the pulse data (SD, SD', SD") of the map pairs (M, M') according to this sub-region (R), preferably wherein respective data of different patients is averaged or optimal respective pulse data (SD, SD', SD") is chosen from pulse data (SD, SD', SD") created of a map pair (M, M').

7. A method for controlling a magnetic resonance imaging system (1), comprising the steps:

- providing a pulse-design unit (12) according to one of claims 1 to 6,
- providing an examination scheme (E) comprising information about the contrasts to be measured and the order of sub-regions (R) of a region of interest to be recorded,
- generating pulse data (SD, SD', SD") with the pulse-design unit (12) based on the examination scheme (E),
- creating a pulse sequence (PS) for a measurement with the magnetic resonance imaging system (1) from the generated pulse data (SD, SD', SD").

8. The method according to claim 7, wherein the pulse data (SD, SD', SD") is calculated by a neural network (N) by measuring map pairs (M, M') of the respective patient and inputting these map pairs (M, M') into the neural network (N).

**9.** The method according to claim 8, wherein the pulse-design unit (12) comprises a neural network (N) that is trained to assign COV to given map pairs (M, M'), wherein during a measurement there is done an acquisition of map pairs (M, M') of a patient and a calculation of COV matching the inputted map pairs (M, M') by the trained neural network (N), wherein preferably a trajectory for pulse data (SD, SD', SD") is defined by the resulting COV data and/or pulse shapes are optimized on the basis of the resulting COV and corresponding pulse shapes.

**10.** The method according to one of claims 7 to 9, wherein pulse data (SD, SD', SD") for the sub-regions are chosen from a dictionary (D) of the pulse-design unit (12) depending on the examination scheme (E),
preferably wherein for the sub-region (R) for which no pulse data (SD, SD', SD") is present in the dictionary (D), intermediate pulse data (SD, SD', SD") is calculated from pulse data (SD, SD', SD") according to sub-regions (R) of the dictionary that are adjacent to the sub-region (R), preferably wherein the creation of the intermediate pulse data (SD, SD', SD") comprises averaging of pulse data (SD, SD', SD") or choosing the pulse data (SD, SD', SD") of the nearest sub-region (R) in the dictionary (D).

**11.** The method according to claim 10, wherein the pulse-design unit (12) comprises dictionary (D) comprising pulse data (SD, SD', SD") in form of prepared pTx pulses for different map pairs (M, M') depending on the position of a slab to be measured, wherein the dictionary (D) preferably assigns each slab position a universal pulse, and wherein pulse data (SD, SD', SD") is chosen from the dictionary (D) based on a slab position to be excited during a measurement defined by the examination scheme (E).

**12.** A control device (13) for controlling a magnetic resonance imaging system (1) comprising:

- a pulse-design unit (12) according to one of claims 1 to 6,
- a data interface (21) designed for receiving an examination scheme (E) comprising information about the contrasts to be measured and the order and shape of sub-regions (R) of a region of interest to be recorded,
- a sequence unit (22) designed for creating a pulse sequence (PS) for a measurement with the magnetic resonance imaging system (1) from pulse data (SD, SD', SD") generated by the pulse-design unit (12).

**13.** A magnetic resonance imaging system (1) comprising a control device (13) according to claim 12.

**14.** A computer program product comprising a computer program that is directly loadable into a computing system or a control device (13) for a magnetic resonance imaging system (1), which comprises program elements for performing steps of the method according to any of claims 7 to 11 when the computer program is executed by the computing system or the control device (13).

**15.** A computer-readable medium on which is stored program elements that can be read and executed by a computer unit in order to perform steps of the method according to any of claims 7 to 11 when the program elements are executed by the computer unit.

# FIG 1

# FIG 2

FIG 3

FIG 4

FIG 5

Europäisches Patentamt
European Patent Office
Office européen des brevets

# EUROPEAN SEARCH REPORT

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | EP 3 594 710 A1 (COMMISSARIAT ENERGIE ATOMIQUE [FR] ET AL.) 15 January 2020 (2020-01-15) * paragraph [0050] * * paragraph [0053] - paragraph [0082] * * figures 1, 2 * * paragraph [0179] - paragraph [0181] * * figure 10 * * paragraphs [0185], [0022], [0023] * ----- | 1-7, 10-15 | INV. G01R33/54 G01R33/561 G01R33/565 |
| X | CHRISTOPHER MIRFIN ET AL: "Optimisation of parallel transmission radiofrequency pulses using neural networks", INTERNATIONAL SOCIETY FOR MAGNETIC RESONANCE IN MEDICINE, 1 June 2018 (2018-06-01), page 3388, XP055740465, * the whole document * ----- | 1,4-9, 12-15 | |
| A,P | JÜRGEN HERRLER ET AL: "Fully embedded parallel transmission: Stable performances using universal pulses with fast online customization", INTERNATIONAL SOCIETY FOR MAGNETIC RESONANCE IN MEDICINE, 24 July 2020 (2020-07-24), page 3694, XP055740768, * the whole document * ----- | 9 | TECHNICAL FIELDS SEARCHED (IPC) G01R |

The present search report has been drawn up for all claims

| Place of search | Date of completion of the search | Examiner |
|---|---|---|
| Munich | 16 October 2020 | Vanhaecke, Nicolas |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 20 17 1345

This annex lists the patent family members relating to the patent documents cited in the above-mentioned European search report.
The members are as contained in the European Patent Office EDP file on
The European Patent Office is in no way liable for these particulars which are merely given for the purpose of information.

16-10-2020

| Patent document cited in search report | | Publication date | Patent family member(s) | | Publication date |
|---|---|---|---|---|---|
| EP 3594710 | A1 | 15-01-2020 | EP 3594710 | A1 | 15-01-2020 |
| | | | JP 2020006162 | A | 16-01-2020 |
| | | | KR 20200006003 | A | 17-01-2020 |
| | | | US 2020011953 | A1 | 09-01-2020 |

EPO FORM P0459

For more details about this annex : see Official Journal of the European Patent Office, No. 12/82